# EUROPEAN PATENT APPLICATION

(11) **EP 3 399 848 A1**
(43) Date of publication of application: **07.11.2018**
(21) Application number: 16880593.5
(22) Date of filing: 08.08.2016
(51) Int. Cl.: H05K 1/02

(54) **FLEXIBLE CIRCUIT BOARD WIRING STRUCTURE AND MOBILE TERMINAL**

(30) Priority: 29.12.2015 CN 201511025618
(71) Applicant: Guangdong Oppo Mobile Telecommunications Corp., Ltd., Dongguan, Guangdong 523860 (CN)
(72) Inventor: CHEN, Yan, Dongguan Guangdong 523860 (CN)
(74) Representative: Johnson, Richard Alan
(86) International application number: PCT/CN2016/093914
(87) International publication number: WO 2017/113798

(57) **Abstract**

A flexible printed circuit (FPC) wiring structure (130) and a mobile terminal (1) are provided. The FPC wiring structure (130) includes a FPC body (100). The FPC body (100) is a single-layer board. The FPC body (100) includes a substrate layer (10) and a signal line (20), a first wire (30), and a second wire (40) arranged on the substrate layer (10). The signal line (20) includes a first wiring area (21) disposed on one side of the signal line (20) and a second wiring area (22) disposed on the other side of the signal line (20). The first wire (30) is arranged in the first wiring area (21) and the second wire (40) is arranged in the second wiring area (22). A distance between the first wire (30) and the signal line (20) is equal to that between the second wire (40) and the signal line (20). With aid of ground networks on both sides of the signal line (20), wiring is performed to form reference loops of the signal line (20). The distance between the first wire (30) and the signal line (20) is controlled to be equal to that between the second wire (40) and the signal line (20), so that impedance environments at both sides of the signal line (20) can be kept consistent, therefore achieving continuity of impedance and solving the problem of the continuity of signal impedance on a single-layer board.

## Description

### TECHNICAL FIELD

The present disclosure relates to the field of electrical connection, and particularly to a flexible printed circuit (FPC) wiring structure and a mobile terminal.

### BACKGROUND

A flexible printed circuit (FPC) generally adopts a multi-layer board design in order to meet wiring requirements. However, for wiring design of a multi-layer board, in order to ensure continuity of signal impedance, wiring is generally arranged on a position of next layer of a current layer of the signal line and exactly corresponding to the signal line, so as to use wiring of the current layer as a reference loop. As the ever-increasing demands of users for a thinner thickness of the mobile terminal, the FPC with a multi-layer board design will occupy a relatively large space since the multi-layer board is relatively thick. This is not conducive to a thinning design of the mobile terminal and affects user experience.

When wiring on a single-layer FPC, because the FPC is a single-layer board structure, wiring cannot be conducted in the corresponding position of the next layer of the signal line. This cannot meet the impedance continuity requirements.

Therefore, it is desirable to provide a FPC wiring structure that adopts the single-layer FPC and satisfies the impedance continuity of the single-layer FPC.

### SUMMARY

This disclosure aims to provide a flexible printed circuit (FPC) wiring structure and a mobile terminal. The FPC adopts a single-layer board design and satisfies impedance continuity of the single-layer board.

Implementations of this disclosure provide following technical solutions.

According to a first aspect of the disclosure, there is provided a FPC wiring structure, which includes a FPC body. The FPC body is a single-layer board. The FPC body includes a substrate layer and a signal line, a first wire, and a second wire that are arranged on the substrate layer. The signal line includes a first wiring area disposed on one side of the signal line and a second wiring area disposed on the other side of the signal line. The first wire is arranged in the first wiring area and the second wire is arranged in the second wiring area. A distance between the first wire and the signal line is equal to that between the second wire and the signal line.

According to a second aspect of the disclosure, there is provided a mobile terminal, which includes a FPC wiring structure. The FPC wiring structure includes a FPC body. The FPC body is a single-layer board and includes a substrate layer and a signal line, a first wire, and a second wire that are arranged on the substrate layer. The signal line includes a first wiring area disposed on one side of the signal line and a second wiring area disposed on the other side of the signal line. The first wire is arranged in the first wiring area and the second wire is arranged in the second wiring area. A distance between the first wire and the signal line is equal to that between the second wire and the signal line.

According to the FPC wiring structure of the disclosure, the FPC body is designed as the single-layer board and the signal line is disposed on the substrate layer of the FPC body. The first wire is arranged in the first wiring area, the second wire is arranged in the second wiring area, and the first wire and the second wire are arranged symmetrically relative to the signal line, to ensure that the distance between the first wire and the signal line is equal to that the second wire and the signal line. Since the FPC body is a single-layer board, wiring can be arranged by using ground networks on both sides of the signal line respectively to be used as reference loops of the signal line. Then the distance between the first wire and the signal line is controlled to be equal to that between the second wire and the signal line, such that impedance environments at both sides of the signal line can be kept consistent, therefore achieving continuity of impedance. In this way, it is possible to solve the problem of signal impedance continuity on a single-layer board. When the FPC wiring structure is applied to the mobile terminal, the space occupied by the FPC wiring structure in the mobile terminal can be reduced, whereby the overall thickness of the mobile terminal can be reduced and user experience can be improved.

### BRIEF DESCRIPTION OF THE DRAWINGS

In order to illustrate the technical solutions embodied by the embodiments of the present disclosure or by the related art more clearly, the following briefly introduces the accompanying drawings required for describing the embodiments or the related art. Apparently, the accompanying drawings in the following description merely illustrate some embodiments of the present disclosure. Those of ordinary skill in the art may also obtain other drawings based on these accompanying drawings without creative efforts.
FIG.1 is a schematic structural diagram illustrating a FPC wiring structure according to a first embodiment of the disclosure.
FIG.2 is a schematic structural diagram illustrating a FPC wiring structure of FIG.1 from another angle of view.
FIG.3 is a block diagram illustrating a mobile terminal according to an embodiment of the disclosure.

### DETAILED DESCRIPTION OF ILLUSTRATED EMBODIMENTS

Technical solutions of the embodiments of the present disclosure will be described clearly and completely hereinafter with reference to the accompanying drawings in the embodiments of the present disclosure. Apparently, the described embodiments are merely some rather than all embodiments of the present disclosure. All other embodiments obtained by those of ordinary skill in the art based on the embodiments of the present disclosure without creative efforts shall fall within the protection scope of the present disclosure.

A flexible printed circuit (FPC) wiring structure is provided. The FPC wiring structure includes a FPC body. The FPC body is a single-layer board and includes a substrate layer and a signal line, a first wire, and a second wire that are arranged on the substrate layer. The signal line includes a first wiring area disposed on one side of the signal line and a second wiring area disposed on the other side of the signal line. The first wire is arranged in the first wiring area and the second wire is arranged in the second wiring area. A distance between the first wire and the signal line is equal to that between the second wire and the signal line.

Traces of the first wire and the second wire are consistent with that of the signal line.

The signal line, the first wire, and the second wire are straight wires or serpentine wires. The first wire, the second wire, and the signal line are disposed in parallel.

The distance between the first wire and the signal line is greater than or equal to twice the line width of the signal line. The distance between the second wire and the signal line is greater than or equal to twice the line width of the signal line.

The first wire has a line width greater than or equal to triple the line width of the signal line and the second wire has a line width greater than or equal to triple the line width of the signal line.

The first wiring area has an area equal to that of the second wiring area.

The signal line is a single-ended signal line or a differential signal line.

The signal line further includes a third wiring area and a fourth wiring area, where the third wiring area is disposed on one side of the first wiring area and the fourth wiring area is disposed on one side of the second wiring area. The FPC body further includes a third wire and a fourth wire, the third wire is arranged in the third wiring area, and the fourth wire is arranged in the fourth wiring area.

The third wire and the fourth wire are straight wires or serpentine wires.

A mobile terminal is provided. The mobile terminal includes a FPC wiring structure. The FPC wiring structure includes a FPC body. The FPC body is a single-layer board and includes a substrate layer and a signal line, a first wire, and a second wire that are arranged on the substrate layer. The signal line includes a first wiring area disposed on one side of the signal line and a second wiring area disposed on the other side of the signal line. The first wire is arranged in the first wiring area, the second wire is arranged in the second wiring area, and a distance between the first wire and the signal line is equal to that between the second wire and the signal line.

Traces of the first wire and the second wire are consistent with that of the signal line.

The signal line, the first wire, and the second wire are straight wires or serpentine wires. The first wire, the second wire, and the signal line are disposed in parallel.

The distance between the first wire and the signal line is greater than or equal to twice the line width of the signal line. The distance between the second wire and the signal line is greater than or equal to twice the line width of the signal line.

The first wire has a line width greater than or equal to triple the line width of the signal line. The second wire has a line width greater than or equal to triple the line width of the signal line.

The first wiring area has an area equal to that of the second wiring area.

The signal line is a single-ended signal line or a differential signal line.

The signal line further includes a third wiring area and a fourth wiring area, the third wiring area is disposed on one side of the first wiring area, and the fourth wiring area is disposed on one side of the second wiring area. The FPC body further includes a third wire arranged in the third wiring area and a fourth wire arranged in the fourth wiring area.

The third wire and the fourth wire are straight wires or serpentine wires.

The mobile terminal further includes a body and a mainboard disposed inside the body. The FPC wiring structure is disposed on the mainboard and electrically connected with the mainboard.

The mobile terminal is a smart mobile terminal including a mobile phone, a PC, a tablet, a hand-held game player, and a media player.

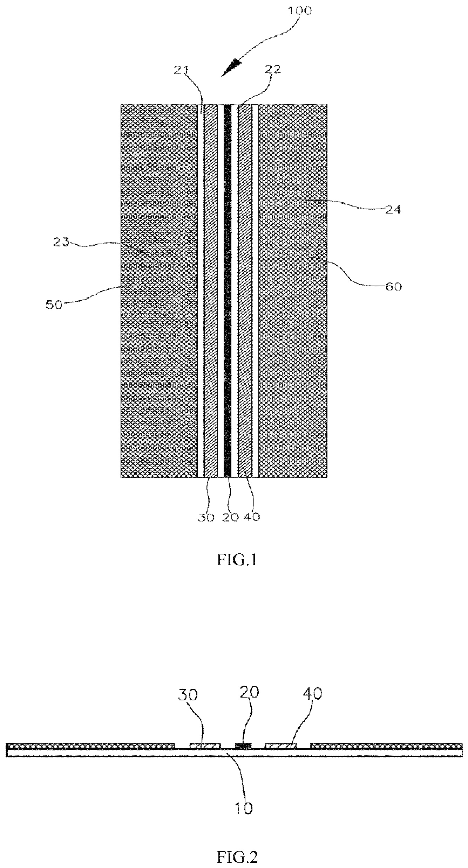

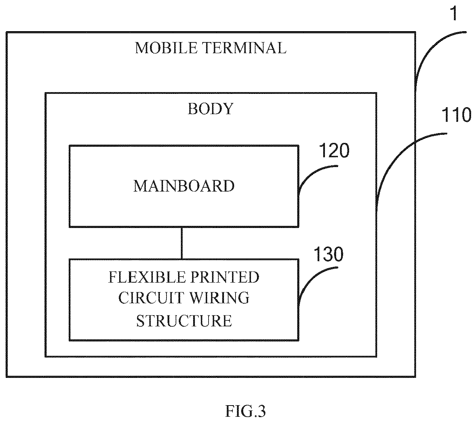

Referring to FIGS.1-3 together, a mobile terminal 1 is provided in the embodiments of the disclosure. As illustrated in FIG.3, the mobile terminal 1 includes a body 110, a mainboard 120 and a flexible printed circuit (FPC) wiring structure 130 disposed inside the body 110. The FPC wiring structure 130 is disposed inside the body 110 and electrically connected with the mainboard 120.

The mobile terminal 1 can be a smart mobile terminal such as a mobile phone, a PC, a tablet, a hand-held game player, and a media player. The following describes a mobile phone as an example of the mobile terminal 1.

Referring to FIG.1 and FIG.2 together, a FPC wiring structure 130 is provided. The FPC wiring structure 130 includes a FPC body 100. The FPC body 100 is a single-layer board. The FPC body 100 includes a substrate layer 10 and a signal line 20, a first wire 30, and a second wire 40 that are arranged on the substrate layer 10. The signal line 20 includes a first wiring area 21 disposed on one side of the signal line 20 and a second wiring area 22 disposed on the other side of the signal line 20. The first wire 30 is arranged in the first wiring area 21 and the second wire 40 is arranged in the second wiring area 22. A distance between the first wire 30 and the signal line 20 is equal to that between the second wire 40 and the signal line 20.

According to the FPC wiring structure 130 of the disclosure, the FPC body 100 is designed as a single-layer board. The first wire 30 is arranged on one side of the signal line 20 of the FPC body 100, the second wire 40 is arranged on the other side of the signal line 20 of the FPC body 100, and the distance between the first wire 30 and the signal line 20 is equal to that between the second wire 40 and the signal line 20, so that signal impedance environments at both sides of the signal line 20 can be kept consistent, which is conducive to ensuring continuity of impedance of the signal line 20. In addition, the first wire 30 is arranged on one side of the signal line 20 and the second wire 40 is arranged on the other side of the signal line 20, the first wire 30 and the second wire 40 can be used as reference loops of the signal line 20. In this way, it is possible to meet the requirements of impedance environments when the FPC body 100 is a single-layer board, thereby ensuring signal impedance continuity on the single-layer board.

In at least one implementation, the FPC body 100 is a single-layer board. The FPC body 100 includes a substrate layer 10 and a copper foil layer (not illustrated). The signal line 20, the first wire 30, and the second wire 40 are arranged on the copper foil layer.

The substrate layer 10 is an insulation layer and can be made of Polyimide (PI) material, Polyethylene terephthalate (PET) material, or other materials. Alternatively, the substrate layer 10 can be made of a FR-4epoxy glass cloth (FR4), in order to provide an insulation environment to facilitate the etching of the copper foil layer when the copper foil layer is disposed on the substrate layer 10. As an example, the substrate layer 10 can have a thickness of 20 *µ*m.

In this implementation, the signal line 20 can be a single-ended signal line or a differential signal line, such that the FPC wiring structure 130 can meet different signal transmission requirements. As an example, when the signal needs to have a strong anti-common-mode interference ability and needs to be transmitted over a long distance, the signal line 20 can be implemented via a differential signal line. As another example, when the signal transmission distance is not long and requirements on anti-interference ability are not high, the signal line 20 can be implemented via a single-ended signal line.

Further, the signal line 20 can be a straight wire or a serpentine wire, such that the signal line 20 can meet the requirements of different time series. For example, when the signal line 20 needs to adjust the time delay, the signal line 20 can adopt the serpentine wire.

The first wiring area 21 is arranged on one side of the signal line 20 and the second wiring area 22 is arranged on the other side of the signal line 20. In this implementation, the first wiring are 21 has an area equal to that of the second wiring area 22, so as to keep impedance environments at both sides of the signal line 20 consistent. As an example, areas of the first wiring area 21 and the second wiring area 22 are both greater than twice the line width of the signal line 20, therefore, when the first wire 30 is arranged in the first wiring area 21 and the second wire 40 is arranged in the second wiring area 22, the first wire 30 and the second wire 40 can be close to the signal line 20 to facilitate coupling with the signal line 20, therefore meeting wiring signal impedance requirements of the signal line 20. In at least one implementation, the areas of the first wiring area 21 and the second wiring area 22 can be adjusted according to the actual wiring condition of the FPC body 100.

In at least one implementation, the signal line 20 further includes a third wiring area 23 and a fourth wiring area 24, the third wiring area 23 is arranged on one side of the first wiring area 21, and the fourth wiring area 24 is arranged on one side of the second wiring area 22. The FPC body 100 further includes a third wire 50 and a fourth wire 60, the third wire 50 is arranged in the third wiring area 23, and the fourth wire 60 is arranged in the fourth wiring area 24. In one implementation, the third wiring area 23 and the fourth wiring area 24 are respectively configured to arrange other signal wires, such as a clock signal line or other wires. The third wire 50 and the fourth wire 60 can also be straight wires or the serpentine wires. Traces of the third wire 50 and the fourth wire 60 can be selected according to actual wiring requirements, and not need to be consistent with the signal line 20.

Traces of the first wire 30 and the second wire 40 are consistent with the signal line 20. The first wire 30 and the second wire 40 are in parallel with the signal line 20. In this implementation, when the signal line 20 is a straight wire, the first wire 30 and the second wire 40 are also the straight wires. Similarly, when the signal line 20 is a serpentine wire, the first wire 30 and the second wire 40 are both serpentine wires. By setting the traces of the first wire 30 and the second wire 40 to be consistent with the signal line 20 and ensuring that the first wire 30 and the second wire 40 are in parallel with the signal line 20, the first wire 30 and the second wire 40 can be used as reference loops of the signal line 20. By further ensuring the distance between the first wire 30 and the signal line 20 is equal to that between the second wire 40 and the signal line 20, signal environments at both sides of the signal line 20 can be kept consistent, thereby impedance signal of the signal line 20 can be kept consistent. That is, in this way, it is possible to ensure that a resistance value of the signal line 20 relative to the first wire 30 is equal to that of the signal line 20 relative to the second wire 40.

In one implementation, since the distance between the first wire 30 and the signal line 20 is greater than or equal to twice the line width of the signal line 20, and the distance between the second wire 40 and the signal line 20 is greater than or equal to twice the line width of the signal line 20, the signal coupling condition of the signal line 20 can be satisfied. In addition, when the first wire 30 and the second wire 40 are closer to the signal line 20, a stronger signal coupling strength between the signal line 20 and the first wire 30 as well as between the signal line 20 and the second wire 40 can be obtained, and a better impedance continuity of the signal line 20 can be achieved. In one implementation, the distance between the first wire 30 and the signal line 20 is equal to twice the line width of the signal line 20, and the distance between the second wire 40 and the signal line 20 is equal to twice the line width of the signal line 20.

In at least one implementation, the first wire 30 has a line width greater than or equal to triple the line width of the signal line 20 and the second wire 40 has a line width greater than or equal to triple the line width of the signal line 20, so that the signal coupling strength between the signal line 20 and the first wire 30 as well as the signal coupling strength between the signal line 20 and the second wire 40 can be further strengthened, therefore ensuring that the signal line 20 has sufficient reference loops. In at least one implementation, in a specific wiring design process, the distance between the signal line 20 and the first wire 30 as well as the distance between the signal line 20 and the second wire 40 can be calculated by using a impedance simulation software, so that impedance control can be further facilitated, thereby improving signal transmission quality of the FPC wiring structure.

According to the FPC wiring structure of the disclosure, the FPC body is set as the single-layer board and the signal line is disposed on the substrate layer of the FPC body. The first wire is arranged in the first wiring area of the signal line, the second wire is arranged in the second wiring area of the signal line, and the first wire and the second wire are arranged symmetrically relative to the signal line, to ensure that the distance between the first wire and the signal line is equal to that between the second wire and the signal line. Since the FPC body is a single-layer board, wiring is conducted by using ground networks (i.e., ground wires) on both sides of the signal line respectively, such that the wiring can be used as reference loops of the signal line. Then the distance between the first wire and the signal line is controlled to be equal to that between the second wire and the signal line, so that impedance environments at both sides of the signal line can be kept consistent, therefore achieving impedance continuity. In this way, it is possible to solve the problem of signal impedance continuity on the single-layer board, such that when the FPC wiring structure is applied to a mobile terminal, a space occupied by the FPC wiring structure in the mobile terminal can be reduced, which is beneficial to reducing the overall thickness of the mobile terminal and improving user experience.

While the present disclosure has been described in detail above with reference to the exemplary embodiments, the scope of the present disclosure is not limited thereto. As will occur to those skilled in the art, the present disclosure is susceptible to various modifications and changes without departing from the spirit and principle of the present disclosure. Therefore, the scope of the present disclosure should be determined by the scope of the claims.

## Claims

1. A flexible printed circuit, FPC, wiring structure, comprising a FPC body, the FPC body being a single-layer board and comprising:
a substrate layer; and
a signal line, a first wire, and a second wire arranged on the substrate layer;
the signal line comprising a first wiring area disposed on one side of the signal line and a second wiring area disposed on the other side of the signal line, the first wire being arranged in the first wiring area and the second wire being arranged in the second wiring area, and a distance between the first wire and the signal line being equal to that between the second wire and the signal line.

2. The FPC wiring structure of claim 1, wherein traces of the first wire and the second wire are consistent with that of the signal line.

3. The FPC wiring structure of claim 2, wherein the signal line, the first wire, and the second wire are straight wires or serpentine wires; wherein the first wire and the second wire are in parallel with the signal line.

4. The FPC wiring structure of claim 1, wherein the distance between the first wire and the signal line is greater than or equal to twice the line width of the signal line, the distance between the second wire and the signal line is greater than or equal to twice the line width of the signal line.

5. The FPC wiring structure of claim 1, wherein the first wire and the second wire each has a line width greater than or equal to triple the line width of the signal line.

6. The FPC wiring structure of claim 1, wherein the first wiring area has an area equal to that of the second wiring area.

7. The FPC wiring structure of claim 1, wherein the signal line is a single-ended signal line or a differential signal line.

8. The FPC wiring structure of claim 1, wherein the signal line further comprises a third wiring area disposed on one side of the first wiring area and a fourth wiring area disposed on one side of the second wiring area; wherein the FPC body further comprises a third wire arranged in the third wiring area and a fourth wire arranged in the fourth wiring area.

9. The FPC wiring structure of claim 8, wherein the third wire and the fourth wire are straight wires or serpentine wires.

10. A mobile terminal, comprising a FPC wiring structure, the FPC wiring structure comprising a FPC body, the FPC body being a single-layer board and comprising:
a substrate layer; and
a signal line, a first wire, and a second wire arranged on the substrate layer;
the signal line comprising a first wiring area disposed on one side of the signal line and a second wiring area disposed on the other side of the signal line, the first wire being arranged in the first wiring area and the second wire being arranged in the second wiring area, and a distance between the first wire and the signal line being equal to that between the second wire and the signal line.

11. The FPC wiring structure of claim 10, wherein traces of the first wire and the second wire are consistent with that of the signal line.

12. The FPC wiring structure of claim 11, wherein the signal line, the first wire, and the second wire are straight wires or serpentine wires; wherein the first wire, the second wire, and the signal line are disposed in parallel.

13. The FPC wiring structure of claim 10, wherein the distance between the first wire and the signal line is greater than or equal to twice the line width of the signal line, the distance between the second wire and the signal line is greater than or equal to twice the line width of the signal line.

14. The FPC wiring structure of claim 10, wherein the first wire and the second wire each has a line width greater than or equal to triple the line width of the signal line.

15. The FPC wiring structure of claim 10, wherein the first wiring area has an area equal to that of the second wiring area.

16. The FPC wiring structure of claim 10, wherein the signal line is a single-ended signal line or a differential signal line.

17. The FPC wiring structure of claim 10, wherein the signal line further comprises a third wiring area disposed on one side of the first wiring area and a fourth wiring area disposed on one side of the second wiring area; wherein the FPC body further comprises a third wire arranged in the third wiring area and a fourth wire arranged in the fourth wiring area.

18. The FPC wiring structure of claim 17, wherein the third wire and the fourth wire are straight wires or serpentine wires.

19. The FPC wiring structure of claim 10, wherein the mobile terminal further comprises a body and a mainboard disposed inside the body; wherein the FPC wiring structure is disposed on the mainboard and electrically connected with the mainboard.

20. The FPC wiring structure of claim 10, wherein the mobile terminal is a smart mobile terminal comprising a mobile phone, a PC, a tablet, a hand-held game player, and a media player.
